# EUROPEAN PATENT SPECIFICATION

(11) **EP 0 480 915 B1**
(45) Date of publication and mention of the grant of the patent: **22.11.1995**
(21) Application number: 92200063.3
(22) Date of filing: 13.08.1986
(51) Int. Cl.: G06F 11/20

(54) **Defective element disabling circuit having a laser-blown fuse**
Schaltung zur Ausschaltung von Fehlerhaften Elementen mit durch Laser durchgebrannter Sicherung
Circuit de mise hors service d'éléments défectueux ayant un fusible fondu par laser

(30) Priority: 20.08.1985 US 767404
(43) Date of publication of application: 15.04.1992
(62) Divisional of application: 86401808.0
(73) Proprietor: SGS-THOMSON MICROELECTRONICS, INC., Carrollton Texas 75006-5039 (US)
(72) Inventor: Johnson, Mark G., Los Altos, CA 94022 (US); Taylor, Ronald T., Grapevine, TX 76051 (US)
(74) Representative: Driver, Virginia Rozanne

(56) References cited:
- EP-A- 0 131 930
- IEEE JOURNAL OF SOLID-STATE CIRCUITS. vol. SC-18, no. 5, October 1983, NEW YORK US pages 544 - 550; YOSHIDA ET AL: 'A 288K CMOS EPROM with Redundancy'

## Description

The field of the invention is that of integrated circuits having redundant elements, in particular to defective element disabling circuits having a laser blown fuse for memory circuits having redundant rows or columns.

The use of redundant rows or columns of elements in integrated circuit memories is well known in the art. A conventional method of implementing such redundancy is shown in an article by K. Kokkonen, P.O. Sharp, R. Albers, J.P. Dishaw, F. Louie and R.J. Smith titled "Redundancy Techniques for Fast Static Rams", Digest of Technical Papers, IEEE 1981 International Solid State Circuits Conference, pages 80-81. In this conventional approach a redundant activation circuit recognises the address of a defective element, through laser programming or an equivalent method, and sends a disable signal ("NED") that electrically disables the decoders of all the regular elements in the memory array. The defective element is thus disabled, as well as all the other elements. The spare row or column that was programmed to recognise that particular address is then free to generate its output signal. The advantage of this method is that only one decoder needs to be programmed for each defect - the decoder on the spare row or column. There is no need to program the defective row or column to disable it because all rows or columns are electrically disabled. A well known disadvantage of this method is that the disable signal (NED) must drive a large capacitance since it is connected to all of the rows and columns, not just to a defective one. There is thus a larger or longer response time for repaired elements than there is for normal elements and the specification of the circuit must be altered to allow for this extra response time.

Another prior art circuit, shown in a paper by Smith, Bateman, Sharp, Dishaw and Smudski, FAM 18.3, ISSCC 1982, pages 252-253, teaches away from the invention in that it teaches the use of a NED approach for rows together with a column-disabling system for disabling only one out of a set of eight selected columns that employs an extremely large pull-down resistor, having a value of 1000 megohms, in a series connection with a fuse connected to the gate of a column pass transistor.

EP-A-0131930 describes a memory device in which, when there is a defective portion in the memory cells, those memory cells are substituted by redundancy memory cells. Fuse elements corresponding to the defective memory cells are blown so that the voltages of select lines for the defective memory cells are held at a low level by resistors or transistors to avoid selection of the defective cells.

EP-A-0 131 930 in particular discloses row selection circuits comprising a NAND-gate, having its output coupled via buffer circuits to a fuse element, which is further connected to the input of a NOR gate which drives row/column lines, and wherein a pull-up transistor is connected to the input of the NOR gates.

This circuit suffers from the disadvantage that there is the possibility that the low state of the select lines could be altered inadvertently by noise coupling into the circuit from noise sources. This is clearly undesirable.

IEEE Journal of solid state circuits, Vol. SC-18, No.5, Oct. 1983, p. 544-550, In Fig. 5(a) discloses a conventional row decoder exhibting the NAND structure as defined in Claim 1.

According to the present invention there is provided a row decoder circuit for use in a semiconductive memory comprising an array of storage elements arranged in rows and columns and including redundant rows comprising:
a NAND gate including a plurality of input terminals;
said NAND gate comprising a plurality of N-channel transistors having their drain source paths connected in series between ground and a first node and an equal number of P-channel transistors having their drain source paths connected in parallel between a point of high voltage and a second node, the gate electrode of an N-channel transistor being connected to a gate electrode of a respective P-channel transistor and to a separate one of said input terminals;
a fuse element that is blown open when there is a defective element in the row associated with the decoder circuit having a first terminal connected to said first node and a second terminal connected to said second node;
a pull up P-channel transistor having its drain source path connected between a point of high voltage and said second node and its gate electrode connected to ground; and
an invertor having its input connected only to said second node and its output connected only to an output node to be controlled and the current carrying capacity of the pull up transistor is small compared to the current carrying capacity of the current path through the NAND circuit to ground whereby the output node provides a low impedance independent of the state of the fuse.

This application is divisional application to European Application EP-A-0 213 044.

The invention relates to a decoder circuit for disabling a defective element in a circuit where there are redundant elements available. The decoder scheme employs a fuse on a signal path through the decoder and a default circuit for controlling the output state of the decoder when the signal path is in a high impedance state, such as when a laser-blown fuse is open.

A feature of the invention is the suppression of noise coupled into the circuit by the provision of a low-impedance path from the enabling line to either ground or VCC.

For a better understanding of the invention and to show how the same may be carried into effect, reference will now be made by way of example to the accompanying Figures in which:
Figure 1 illustrates a prior art method of controlling redundant elements;
Figure 2 illustrates another prior art method; and
Figure 3 illustrates an embodiment of the invention.

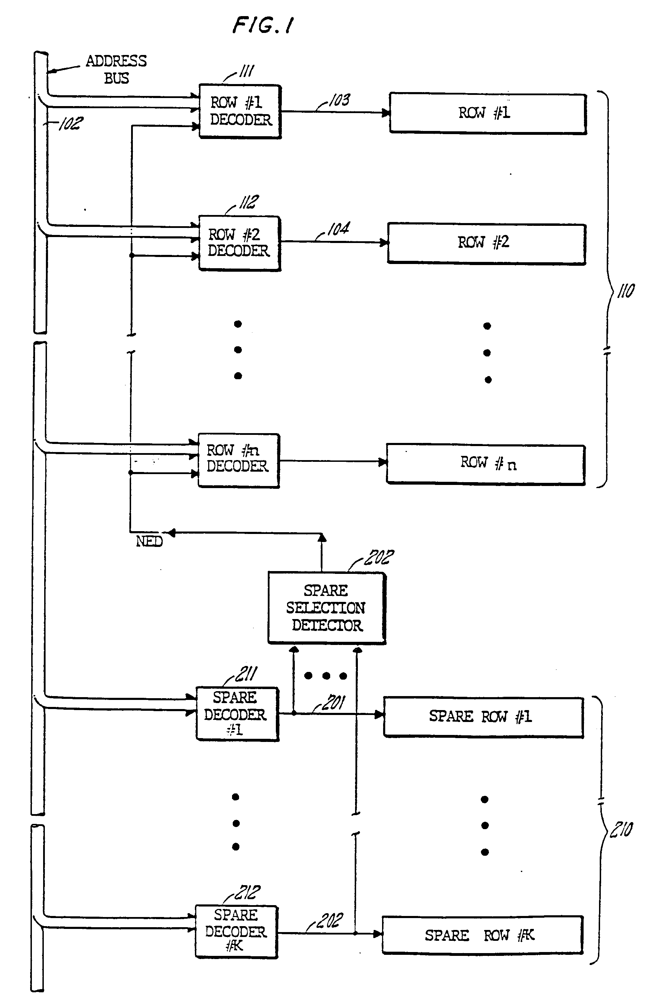

In Figure 1, a prior art embodiment referred to above is illustrated, in which a memory array indicated by the bracket labelled 110 and a redundant set of rows indicated by the bracket labelled 210 are both connected to a set of decoders and thus to a common address bus 102. The address bus transmits addresses to a set of conventional decoders, indicated by 111 and 112 in the Figure, and spare decoders indicated by the numerals 211 and 212. Each decoder, which is conventional in the art, will respond to its particular address by activating an output line that will enable the row or column to which it is connected. When one row is defective, that row must be disabled and one of the spare rows must be enabled to respond to the correct address. Spare selection detector circuit 202 in the Figure has the form illustrated in the above reference and responds to any activation signal from a spare decoder on one of lines 201 or 202 in the drawing to generate a normal element disable signal, referred to as NED, that disables all of the decoders in the regular array. The disadvantage of this approach, as was discussed above, is that circuit 202 must drive a large capacitive load because of the many elements that are connected to it, and thus the response of the memory in the case of a defective row takes a longer time than it does for the response to a normal row.

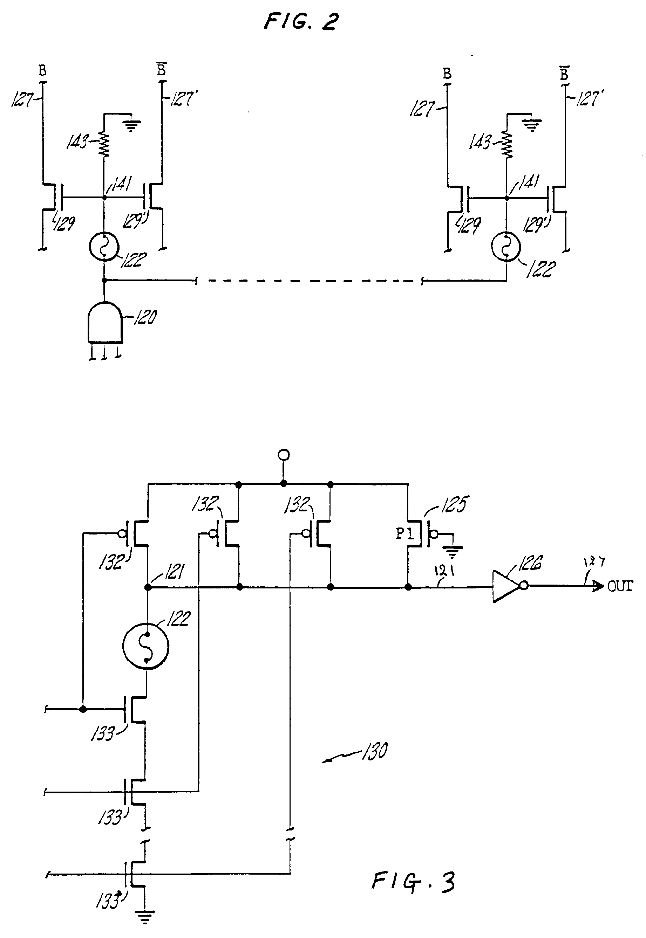

Figure 2 shows a portion of another prior art circuit that is used in the particular case of a by-8 memory in which a single column select signal enables a column in each of eight blocks. Only two blocks are shown in the drawing for simplicity. When only one column is defective, it is necessary to disable only one column out of the eight selected columns in order to use the remaining seven columns. This is accomplished by the circuit shown, in which a decoder 120 output is connected directly to eight fuses 122, each of which is in series with the gates of a pair of pass transistors 129 and 129′ that are connected to BIT and B̅I̅T̅ lines 127 and 127′. The (single) fuse connected to the defective column will be blown. Note that the fuse is not series-connected to the column or row enable line, but only to two transistor gates. Because the decoder must be on pitch with two lines in this case, it must be physically small, and thus can pass only a relatively small amount of current. The single RC time constant resulting from the non-trivial resistance of the fuse and the gate capacitance of the relatively large pass transistors degrades the switching time for this arrangement. Another drawback of this circuit is that the extremely high impedance of the 1000 megohm path to ground through resistor 143 makes this circuit susceptible to noise that is inevitably coupled in to node 141 between the pass transistor gate and the fuse.

Referring now to Figure 3, there is shown the interior of a NAND gate 130 in which a fuse 122 is placed on the series path from ground through each of a plurality of N-channel transistors 133 to output node 121. Reference numerals 132 designate the P-channel transistors of the NAND gate. The NAND gate 130 acts as a row decoder with the output node 121 responding to an address on the address bus. The signal path in this case is from the output node 121 of decoder 130 then through inverter 126 to output node 127. Reference numeral 125 designates a P-channel pull up transistor. The magnitude of transistor 125 is selected so that it is a weak transistor having a relatively small current capacity (say 2 microamperes). Thus, in normal operation, the state of the output node 121 is determined by the NAND gate 130 and transistor 125 will have essentially no effect on the operation of the circuit. In order for this to be accomplished of course, as is well known, the current carrying capacity of the path through circuit 130 to ground must dominate the effect of transistor 125. Those skilled in the art will readily be able to devise transistors having appropriate parameters to achieve this conventional result. In a particular example, the current capacity is 2 milliamperes.

If there is a defective element in the row controlled by node 127, then fuse 122 will be blown by a laser, for example, or by the application of a large electrical current or any other conventional means. Fuse 122 performs the function of blocking the signal through the decoder by preventing the transition of node 121 that generates the high going OUT signal. For purposes of this application this effect will also be referred to as blocking the passage at the output signal. Pull up transistor 125 thus brings node 121 to a permanent voltage level of VCC. That, in turn, causes inverter 126 to put node 127 in the conventional logic 0 state to disable the row to which it is attached. An advantage of this method is that inverter 126 has two low impedance states that are a relatively low-impedance path to either VCC or ground, so that any noise coupling to this row line will be suppressed by the action of the transistors within inverter 126 and the row controlled by node 127 will not be enabled or disabled by noise, even momentarily.

The embodiment of Figure 3 is adapted to use with a decoder having active-high inputs and an output that is also active-high.

An important practical advantage of the invention is that it adds very little extra power dissipation in operation. A DC current path exists only when node 121, the input to inverter 126, is pulled low. This only happens in a decoder that is used in the regular array (a regular decoder). All regular decoders that are not active have their node 121 at the normal state of VCC so that no current is drawn through transistor 125. The extra power consumed by the application of this invention is merely the saturation current of one pull up transistor 125, independent of the total number of rows in the memory array or decoders used in other applications of the circuit.

Another advantage of the invention is that capacitive coupling and cross talk will be suppressed at the decoder output because the decoder output is always connected directly to an inverter. The undesirable prior art circuit of Figure 2 has a high impedance at the pass transistor gates which is susceptible to noise coupled onto node 127′ from some other source.

With respect to the speed at which the circuit operates, the only effect is the slight additional time required to overcome transistor 125 when node 121 is to be driven low. Since transistor 125 is a small transistor, having a small capacitance, this effect is small compared to the delay in operating the conventional circuit illustrated in Figure 1.

## Claims

1. A row decoder circuit for use in a semiconductive memory comprising an array of storage elements arranged in rows and columns and including redundant rows comprising:
a NAND gate (130) including a plurality of input terminals;
said NAND gate (130) comprising a plurality of N-channel transistors (133) having their drain source paths connected in series between ground and a first node and an equal number of P-channel transistors (132) having their drain source paths connected in parallel between a point of high voltage and a second node (121), the gate electrode of an N-channel transistor being connected to a gate electrode of a respective P-channel transistor and to a separate one of said input terminals;
a fuse element (122) that is blown open when there is a defective element in the row associated with the decoder circuit having a first terminal connected to said first node and a second terminal connected to said second node (121);
a pull up P-channel transistor (125) having its drain source path connected between a point of high voltage and said second node and its gate electrode connected to ground; and
an invertor (126) having its input connected only to said second node and its output connected only to an output node (127) to be controlled and wherein the current carrying capacity of the pull up transistor is small compared to the current carrying capacity of the current path through the NAND circuit to ground whereby the output node provides a low impedance independent of the state of the fuse.

## Patentansprüche

1. Reihen- bzw Zeilendekoderschaltung zur Verwendung in einer halbleitenden Speichereinrichtung, mit einer Anordnung von Speicherelementen, die in Reihen bzw. Zeilen und Spalten angeordnet sind und redundante Reihen bzw. Zeilen enthalten, die folgendes aufweist:
ein NAND-Gate (130), das mehrere Eingangsanschlüsse aufweist;
das NAND-Gate (130) weist mehrere N-Kanaltransistoren (133), deren Drain-Source-Pfade in Serie zwischen einem unteren Potential bzw. Erde und einem ersten Knoten angeschlossen sind, und eine gleiche Anzahl von P-Kanaltransistoren (132), deren Drain-Source-Pfade parallel zwischen einem Punkt mit hoher Spannung und einem zweiten Knoten (121) angeschlossen sind, wobei die Gate-Elektrode des N-Kanaltransistors an eine Gate-Elektrode eines jeweiligen P-Kanaltransistors und an einen separaten bzw. getrennten der Eingangsanschlüsse angeschlossen ist;
ein Sicherungselement (122), das durchbrennt, wenn ein defektes Element in der Reihe bzw. Zeile, die mit der Dekoderschaltung verbunden ist, das einen ersten Anschluß, der an den ersten Knoten angeschlossen ist, und einen zweiten Anschluß aufweist, der an den zweiten Knoten (121) angeschlossen ist;
einen Pull-Up-P-Kanaltransistor (125), dessen Drain-Source-Pfad zwischen einem Punkt mit hoher Spannung und dem zweiten Knoten angeschlossen ist und dessen Gate-Elektrode an ein niedriges Potential bzw. an Erde angeschlossen ist; und
einen Inverter (126), dessen Eingang nur an den zweiten Knoten angeschlossen ist und dessen Ausgang nur an den Ausgangsknoten (127) angeschlossen ist, um gesteuert zu werden, und wobei die Strom tragende bzw. transportierende Kapazität des Pull-Up-Transistors klein ist, verglichen mit der Strom tragenden bzw. transportierenden Kapazität des Strompfades durch die NAND-Schaltung zum niedrigen Potential bzw. zur Erde, wodurch der Ausgangsknoten eine niedrige Impedanz unabhängig von dem Zustand der Sicherung zur Verfügung stellt.

## Revendications

1. Circuit décodeur de rangée à utiliser dans une mémoire à semiconducteur comprenant une matrice d'éléments de mémorisation agencés en rangées et en colonnes et contenant des rangées redondantes comprenant :
- une porte NON-ET (130) comprenant plusieurs bornes d'entrée ;
ladite porte NON-ET (130) comprenant plusieurs transistors à canal N (133) ayant leurs trajets drain-source reliés en série entre la terre et un premier noeud et un nombre égal de transistors à canal P (132) ayant leurs trajets drain-source reliés en parallèle entre un point de haute tension et un second noeud (121), l'électrode de grille d'un transistor à canal N étant connectée à une électrode de grille d'un transistor à canal P respectif et à l'une, distincte, desdites bornes d'entrée ;
- un élément fusible (122) qui est ouvert par fusion lorsqu'il y a un élément défectueux dans la rangée associée au circuit décodeur, ayant une première borne reliée audit premier noeud et une seconde borne reliée audit second noeud (121) ;
- un transistor d'excursion haute à canal P (125) ayant son trajet drain-source relié entre un point de haute tension et ledit second noeud et son électrode de grille reliée à la terre ; et
- un inverseur (126) ayant son entrée reliée uniquement audit second noeud et sa sortie reliée uniquement à un noeud de sortie (127) devant être commandé et dans lequel le courant admissible dans le transistor d'excursion haute est faible par rapport au courant admissible à travers le circuit NON-ET sur le trajet de courant vers la terre, afin que le noeud de sortie offre une basse impédance indépendante de l'état du fusible.
